(19) Europäisches Patentamt
European Patent Office
Office européen des brevets

(11) Publication number: 0 434 437 A2

(12) **EUROPEAN PATENT APPLICATION**

(21) Application number: 90314053.1

(51) Int. Cl.$^5$: G03F 7/00

(22) Date of filing: 20.12.90

(30) Priority: 20.12.89 US 453526

(43) Date of publication of application: 26.06.91 Bulletin 91/26

(84) Designated Contracting States: CH DE FR GB LI

(71) Applicant: THE MEAD CORPORATION
Mead World Headquarters Courthouse Plaza Northeast
Dayton Ohio 45463 (US)

(72) Inventor: Liang, Rong-Chang
386 Lightbeam Drive
Centerville, Ohio 45458 (US)
Inventor: Tomlinson, Medha Jayant
2381 Duncan Drive, Apt. 5
Fairborn, Ohio 45324 (US)
Inventor: Shi, Daojun
31-1/2, Frank Street
Dayton, Ohio 45409 (US)
Inventor: Varde, Uday
2551, Woodbluff Lane
Spring Valley, Ohio 45370 (US)
Inventor: Tsai, Yi-Guan
465 Wellington Way
Springboro, Ohio 45066 (US)

(74) Representative: Deans, Michael John Percy et al
Lloyd Wise, Tregear & CO. Norman House
105-109 Strand
London WC2R OAE (GB)

(54) **Photohardenable or thermohardenable compositions and photosensitive materials utilising such photohardenable compositions.**

(57) A photohardenable or thermohardenable composition comprises a free radical addition polymerizable material, a thermal or photo initiator, and an antioxidant including a combination of a primary antioxidant and a secondary antioxidant.

EP 0 434 437 A2

# PHOTOHARDENABLE OR THERMOHARDENABLE COMPOSITIONS AND PHOTOSENSITIVE MATERIALS UTILISING SUCH PHOTOHARDENABLE COMPOSITIONS

The present invention relates to thermohardenable compositions, and to photohardenable compositions and photosensitive materials utilising such compositions.

U.S. Patent Nos. 4,399,209 and 4,440,846 to The Mead Corporation describe cylithographic imaging materials and imaging processes in which images are formed through exposure-controlled release of an image-forming agent from a microcapsule containing a photohardenable composition. The imaging material is exposed image-wise to actinic radiation and the microcapsules are subjected to a uniform rupturing force. Typically the image-forming agent is a color precursor which is released image-wise from the microcapsules to a developer sheet whereupon it reacts with a developer to form a visible image.

Full color cylithographic imaging materials include a photosensitive layer which contains three sets of microcapsules. Each set of microcapsules is sensitive to a different band of radiation in the ultraviolet or blue spectrum and contains a cyan, magenta or yellow image-forming agent. One of the problems which has been encountered in designing commercially acceptable full color imaging materials employing these techniques has been the relatively narrow wavelength band width over which most photohardenable compositions are sensitive to actinic radiation. In most cases, the compositions are only sensitive to ultraviolet radiation or blue light ; e.g., 350 to 480 nm. Furthermore, the absorption spectra of the initiators employed in these microcapsules are never perfectly distinct. There is always a degree of overlap in the absorption curves and sometimes it is substantial. Exposure conditions therefore must be controlled carefully to avoid cross-exposure.

One of the particular advantages of using ionic dye complexes as described in U.S. Patents 4,772,530 and 4,772,541 as initiators of free radical addition reactions is the ability to select from a large number of dyes which absorb at substantially different wavelengths. By selecting a dye which absorbs at a wavelength of 400 nm or greater, the sensitivity of the photosensitive material can be extended well into the visible range. The mechanism whereby these dye complexes absorb energy and generate free radicals is not entirely clear. In the case of cationic dye -- borate complexes it is believed that upon exposure to actinic radiation, the dye in the complex is excited and accepts an electron from the borate anion as follows :

$$D^{+} \quad BR_4^{-} \xrightarrow{h\nu} D\cdot + BR_4\cdot \qquad \text{(Eq. 1)}$$

The borate anion is designed such that the boranyl radical generated upon exposure to light and after electron transfer to the dye (Eq. 1) readily dissociates with the formation of a radical as follows :

$$BR_4\cdot \longrightarrow BR_3 + R\cdot \qquad \text{(Eq. 2)}$$

In a solution of a polymerizable compound, ionic pairing of the counter ion and the dye is believed to provide favorable spacial distribution for promoting electron transfer to such an extent that the transfer occurs even though the lifetime of the excited state is very short. After electron transfer, a radical is generated which initiates free radical addition polymerization or cross-linking of the polymerizable or crosslinkable species in the photohardenable composition.

One of the drawbacks of the foregoing photosensitive materials is their limited shelf life. Over time, when these materials are stored at high temperature and high humidity, the initiator breaks down at least in part as a result of oxidative degradation.

We have found that the shelf life of such compositions is improved through the combined use of primary and secondary antioxidants and optionally a metal chelating agent.

The mechanism of oxidative degradation of free radical polymerizable compositions is known, The respective roles of primary and secondary antioxidants and of metal chelating agents are also known per se.
Primary antioxidants are radical traps. They react with free radicals which form at elevated temperatures and generate inactive species. Some common examples of primary antioxidants are hindered phenols, diarylamines or hindered amines and their oxides, and nitroso compounds such as N-nitrosophenylhydroxylamine aluminum salt. Secondary antioxidants are hydroperoxy scavengers. They interact with the hydroperoxide which results when any radical reacts with oxygen and convert it to an inactive alcohol. Some common examples are phosphites and sulfides. Metal deactivators chelate with trace metal impurities in any polymerizable composition and thereby inactivate the metal which would otherwise catalyze the cleavage of a hydroperoxide.

The present invention provides, in a first aspect thereof, a photohardenable or thermohardenable composition which comprises a free radical addition polymerizable material, a thermal or photo initiator, and an antioxidant including a combination of a primary antioxidant and a secondary antioxidant.

The invention extends to a photosensitive material comprising a support having a layer of photohardenable composition as aforesaid on the surface thereof ; and also to photosensitive material comprising a support having a layer of microcapsules on the surface thereof, at least a portion of the microcapsules containing a photohardenable composition as aforesaid.

In a preferred embodiment, the primary antioxidant is a hindered phenol such as butyrate hydroxytoluene (BHT) and the secondary antioxidant is a hydrolytically stable phosphite, such as 2,2′-ethylidenebis(4,6-di-t-butylphenyl) fluorophosphite.

In copending U.S. Application Ser. No. 390,582 filed August 7, 1989, photohardenable compositions are disclosed in which a combination of an ionic dye complex and an onium salt is used in the initiator system. This composition exhibits excellent film speed but very poor storage stability. Inclusion of a combination of a primary and a secondary antioxidant significantly improves stability.

In one preferred arrangement of our compositions the function of the metal deactivator and the primary antioxidant are combined in one compound (Naugard XL-1 available from Uniroyal).

The invention is hereinafter more particularly described by way of example only with reference to the accompanying drawings in which :

Figs. 1 and 2 are DSC thermograms ; and

Figs. 3 and 4 are graphs illustrating the effect of combinations of materials.

Fig. 1 is a series of DSC thermograms for a photosensitive material containing a hydrolysis resistant fluorophosphite (Ethanox 398). As can be seen in Fig. 1, the low temperature thermal polymerization peak is suppressed significantly in the presence of a small amount of Ethanox 398.

Composition : TMPTA : 100, cyanine borate photoinitiator : 0.533, Ethanox 398 : varied (0 to 0.7 wt%)
Heating rate : 10°C/min, Sample weight : 2 mg, nitrogen atmosphere.

Fig. 2 is a series of DSC thermograms for the same photosensitive material containing a metal deactivator (Naguard XL-1). A suppression of the low temperature thermal polymerization peak is also observed.

Composition : TMPTA : 100, cyanine borate photoinitiator : 0.533, Naugard XL-1 : varied (0 to 1000 ppm).
Heating rate : 10°C/min, Sample weight : 2 mg, nitrogen atmosphere.

Fig. 3 shows the effect of a combination of phosphite and metal deactivator. The onset temperature of thermal polymerization reaches a maximum at certain ratios of the two additives, and is about 20°C higher than the control.

Composition : TMPTA : 100, DIDMA : 1.0, cyanine borate initiator : 0.533, Ethanox 398 : 0.3 to 0.7 wt%, Naugard LX-1 : 0 to 500 ppm.
Heating range : 10°C/min, Sample weight : 2 mg, nitrogen atmosphere.
Control : TMPTA : 100, cyanine borate initiator, 0.533, DIDMA : 1.0.

Figs. 4a and 4b show the effect of combinations of a primary antioxidant (BHT) and Ethanox 398 where the relative photospeed of a photosensitive material containing an onium salt, a cyanine borate initiator and antioxidants are plotted as a function of aging time.

4a Composition : TMPTA : 100, cyanine borate initiator : 0.533, DIDMA : 4.0, $Ph_2I^+PF_6^-$ : 0.058, BHT : varied (0 to 1500 ppm).
4a Control : TMPTA : 100, cyanine borate initiator : 0.533, DIDMA 1.0.
4b Composition : TMPTA : 100, cyanine borate initiator : 0.533, DIDMA : 4.0, $Ph_2I^+PF_6^-$ : 0.058, BHT : 100 to 1000 ppm, Ethanox 398 : 3000 to 7000 ppm.

The term "onium salt" as used herein refers to a salt which does not include an ionic dye moiety and, as such, an onium salt is a separate and distinct compound from the ionic dye complex.

The disclosures of U.S. Patents Nos. 4,399,209 ; 4,440,846 ; 4,576,891 ; 4,772,530 ; and 4,772,541 ; and British Patent Specification 2,113,860 are to be regarded as incorporated herein by reference to the extent that reference thereto may be necessary or desirable for additional detail or examples of preferred materials.

Primary and secondary antioxidants and metal deactivators are known and commercially available compounds. Representative examples of primary antioxidants include sterically hindered phenols such as butyrate hydroxytoluene (BHT), Vitamin E, octadecanyl 3-(3,5-di-t-butyl-4-hydroxy)phenylpropionate sold as Irganox 1076 from Ciba Geigy, pentaerythritol tetrakis [3-(3′,5′-di-t-butyl-4′-hydroxyphenyl)-propionate] sold as Irganox 1010 from Ciba Geigy, 3,3′-di-t-butyl-2,2′-dihydroxy-5,5′-dimethyl-diphenylmethane sold as Cyanox 2246 from American Cyanamid ; diarylamines such as N,N-diphenylamine, phenothiazine and their derivatives ; sterically hindered amines such as sterically hindered piperidine derivatives and their nitroxyl radicals (e.g., Tinuvin 770 from Ciba Geigy) ; nitrosobenzene derivatives such as 2,4,6-tri-t-butylnitrosobenzene and N-nitrosophenylhydroxylamine aluminum salt sold as Q1301 from Wako.

Examples of secondary antioxidants include phosphites such as 2,2-ethylenebis(4,6-di-t-butylphenyl)

fluorophosphite, and substituted triphenylphosphites and thioethers such as esters of thiodipropionic acid with fatty alcohols, e.g., dilauryl thiodipropionate.

Examples of metal deactivators include derivatives of dibenzalhydrozone, diacylhydrozine and oxalamide. One compound which is a combination metal deactivator and primary antioxidant is 2,2'-oxamido bis-(ethyl-3-(3,5-di-t-butyl-4-hydroxyphenl) propionate which is sold by Uniroyal Co. under the designation Naugard XL-1.

These antioxidants are used in the compositions in amounts which will vary with the nature of the monomer and initiator as well as the particular antioxidant which is used. Generally, they are used in an amount less than 10% based on the total weight of the photohardenable composition and typically on the order of 0.005 to 1% (usually, 50-500 ppm for primary antioxidants and metal deactivators, but 0.1-1% for secondary antioxidants).

The teachings herein are generally applicable to any free radical polymerizable composition including photosensitive and thermally curable compositions. Examples of useful thermal initiators and photoinitiators are well known in the art. Some representative examples are benzophenones (substituted and unsubstituted), α-alkoxy phenyl ketones, O-acylated α-oximinoketones, polycylic quinones, xanthones, thioxanthones, halogenated compounds such as chlorosulfonyl and chloromethyl polynuclear aromatic compounds, chlorosulfonyl and chloromethyl heterocyclic compounds, chlorosulfonyl and chloromethyl benzophenones and fluorenones, haloalkanes, α-halo-α-phenylacetophenones ; photoreducible dye-reducing agent redox couples, halogenated paraffins (e.g., brominated or chlorinated paraffin) and benzoin alkyl ethers.

The ionic dye complex is preferably a cationic dye-borate complex and acts as a photoinitiator.

Cationic dye-borate anion complexes are known in the art. Their preparation and use in imaging systems is described in U.S. Patent 4,772,541 These complexes can be represented by the general formula (I) :

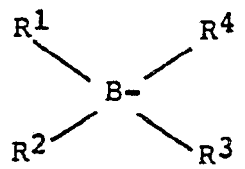

D+

(I)

where D+ is a cationic dye ; and $R^1$, $R^2$, $R^3$ and $R^4$ are independently selected from the group consisting of alkyl, aryl, alkaryl, allyl, aralkyl, alkenyl, alkynyl, alicyclic and saturated or unsaturated heterocyclic groups. One of $R^1$-$R^4$ preferably generates a radical which readily escapes the solvent cage.

Useful dyes suitably form photoreducible but dark stable complexes with borate anions and can be cationic methine, polymethine, triarylmethane, indoline, thiazine, xanthene, oxazine and acridine dyes. More specifically, the dyes may be cationic cyanine, carbocyanine, hemicyanine, dicarbocyanine, tricarbocyanine, rhodamine and azomethine dyes. In addition to being cationic, the dyes should not contain groups which would neutralize or desensitize the complex or render the complex poorly dark stable.

Specific examples of useful cationic dyes are disclosed in U.S. Patent 4,772,541. The preferred dye is a cyanine dye, a dicarbocyanine, or a tricarbocyanine dye as represented by the dyes in the formula (II) :

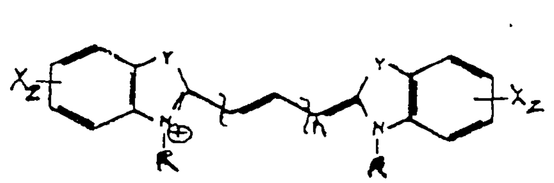

(II)

where n is 0, 1, 2 or 3 ; Z is 1 to 4 ; R is alkyl group and preferably a long chain alkyl group having 6 to 20 (more preferably 6 to 12) carbon atoms ; Y may be the same or different and is CH = CH, > $N-CH_3$, > $C(CH_3)_2$, 0, S, Se ; X is selected based on the desired absorption characteristics of the type and may be selected from a large number of substituents in a manner known in the art. X may be a hydrogen atom ; an electron donating group such as amino, dimethlyamino, hydroxy, methoxy, t-butyl, and methyl ; or X may be an electron withdrawing group such as phenyl, fluoro, chloro, bromo, iodo, —COOH, —COOR where R is a lower alkyl group, methycarbonyl, trifluoromethyl, cyano, methylsulfonyl, and nitro.

Particularly preferred anions are triphenyl-n-butylborate, triphenyl-sec-butyl borate, tris (p-fluorophenyl)-sec-butyl borate and tris(p-fluorophenyl)-n-butyl borate anions because they readily dissociate to triphenylborane or tri(fluorophenyl) borane and a butyl radical upon photoinduced electron transfer to the cationic dye.

Preferably, one of $R^1$, $R^2$, $R^3$, and $R^4$ is an alkyl group (and still more preferably a secondary alkyl group)

and the others are aryl groups. Each of $R^1$, $R^2$, $R^3$, and $R^4$ can contain up to 20 carbon atoms, and they typically contain 1 to 7 carbon atoms. Representative examples of alkyl groups represented by $R^1$-$R^4$ are methyl, ethyl, n-propyl, n-butyl, pentyl, hexyl, octyl, stearyl, sec-butyl, neopentyl, etc. The alkyl groups may be substituted, for example, by one or more halogen, cyano, acyloxy, acyl, alkoxy or hydroxy groups.

Representative examples of aryl groups represented by $R^1$-$R^4$ include phenyl, naphthyl and substituted aryl groups such as anisyl and alkaryl such as methylphenyl, dimethylphenyl, etc. Representative examples of aralkyl groups represented by $R^1$-$R^4$ groups include benzyl and naphthylmethyl. Representative alicyclic groups include cyclobutyl, cyclopentyl, and cyclohexyl groups. Examples of an alkynyl group are propynyl and ethynyl, and examples of alkenyl groups include a vinyl group. Examples of allyl groups are 3,3-diphenyl-2-propenyl, 3,3-dimethyl-2-propenyl, etc.

While the cationic dye complexes described in U.S. Patent 4,772,541 are generally useful in practice of the present invention, the borate substituents must also be selected with regard to the dark stability of the complex in the presence of the onium salts. For example, while triphenylbutylborate is preferred in U.S. Patent 4,772,541, it does not provide optimum dark stability in the presence of a diphenyliodonium salt. A particularly dark stable borate with an iodonium salt is tri-(4-fluorophenyl)butyl borate.

As a general rule, useful cationic dye-borate anion complexes must be identified empirically ; however, potentially useful cationic dye and borate anion combinations can be identified by reference to the Weller equation (Rehm, D. and Weller, A., Isr. J Chem. (1970), 8, 259-271).

The Weller equation will not absolutely predict whether a complex will be useful in practice of the present invention or not. There are a number of other factors which will influence this determination. One such factor is the effect of the monomer on the complex. It is also known that if the Weller equation produces too negative a value, deviations from the equation are possible. Furthermore, the Weller equation only predicts the thermodynamics of electron transfer, it does not predict whether a particular dye complex is an efficient initiator of polymerization. The equation is a useful first approximation.

Specific examples of cationic dye-borate anion complexes useful in practice of the present invention are shown in Table I with their λ max.

TABLE 1

1.

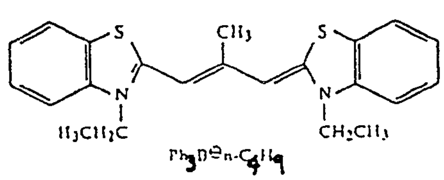

552 nm

2.

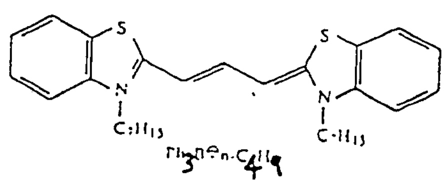

568 nm

3.

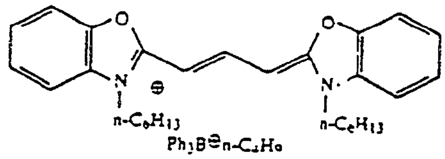

492 nm

4.

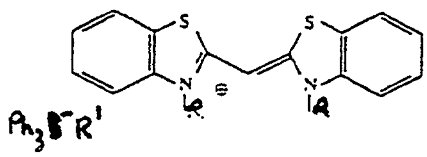

428 nm

R = $C_7$, $C_{10}$, $C_{12}$, $C_{14}$ alkyl
R' = n-butyl or sec-butyl

5.

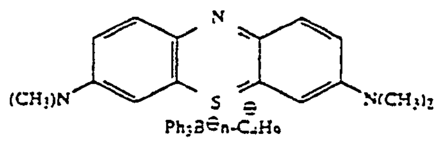

658 nm

6.

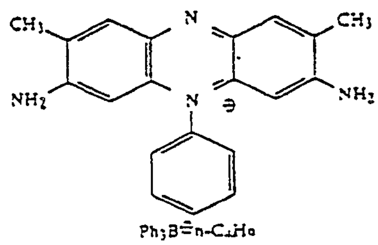

528 nm

7.

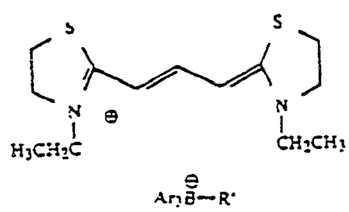

450 nm

| No. | R' | Ar |
|---|---|---|
| 7A | n-butyl | phenyl |
| 7B | n-hexyl | phenyl |
| 7C | n-butyl | anisyl |

8.

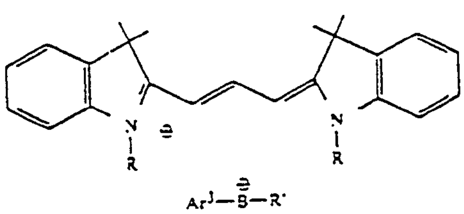

550 nm

| No. | R | R' | Ar | No. | R | R' | Ar |
|---|---|---|---|---|---|---|---|
| 8A | methyl | n-butyl | phenyl | 8H | n-heptyl | sec-butyl | phenyl |
| 8B | methyl | n-hexyl | phenyl | 8I | n-heptyl | cyclopentyl | phenyl |
| 8C | n-butyl | n-butyl | phenyl | 8J | n-heptyl | neopentyl | phenyl |
| 8D | n-butyl | n-hexyl | phenyl | 8K | n-heptyl | benzyl | phenyl |
| 8E | n-heptyl | n-butyl | phenyl | | | | |
| 8F | n-heptyl | n-hexyl | phenyl | | | | |
| 8G | ethyl | n-butyl | phenyl | | | | |

9.

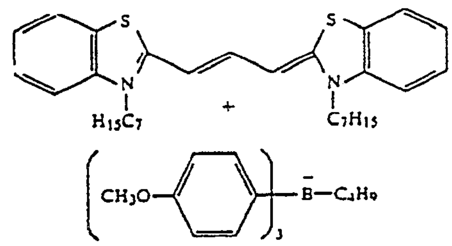

570 nm System

10.

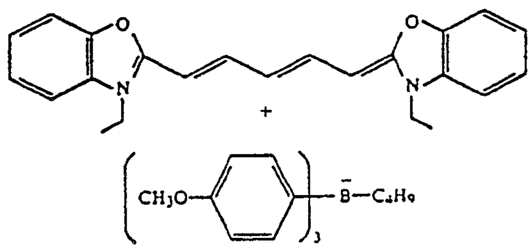

590 nm System

11.

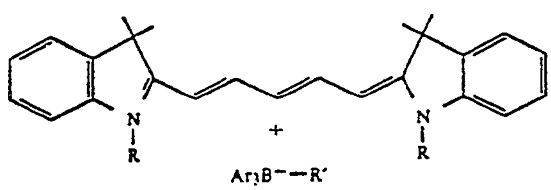

640 nm

| No. | R | R' | Ar | No. | R | R' | Ar |
|---|---|---|---|---|---|---|---|
| 11A | methyl | n-butyl | phenyl | 11J | n-heptyl | sec-butyl | phenyl |
| 11B | methyl | n-hexyl | phenyl | 11K | n-heptyl | cyclopentyl | phenyl |
| 11C | n-butyl | n-butyl | phenyl | 11L | n-heptyl | neopentyl | phenyl |
| 11D | n-butyl | n-hexyl | phenyl | 11M | n-heptyl | benzyl | phenyl |
| 11E | n-phenyl | n-butyl | phenyl | | | | |
| 11F | n-pentyl | n-hexyl | phenyl | | | | |
| 11G | n-heptyl | n-butyl | phenyl | | | | |
| 11H | n-heptyl | n-hexyl | phenyl | | | | |
| 11I | methyl | n-butyl | anisyl | | | | |

12.

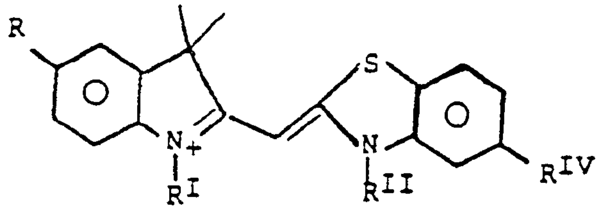

$Ar_3BR^{III}$

| No. | R | $R^I$ | $R^{II}$ | $R^{III}$ | $R^{IV}$ | Ar |
|---|---|---|---|---|---|---|
| 12A | H | $CH_3$ | n-heptyl | n-butyl | H | phenyl |
| 12B | H | $CH_3$ | n-heptyl | sec-butyl | H | phenyl |
| 12C | Cl | $CH_3$ | n-heptyl | n-butyl | H | phenyl |
| 12D | Cl | $CH_3$ | n-heptyl | sec-butyl | H | phenyl |
| 12E | H | $CH_3$ | n-heptyl | n-butyl | $OCH_3$ | phenyl |
| 12F | Cl | $CH_3$ | n-heptyl | n-butyl | $OCH_3$ | phenyl |
| 12G | Cl | $CH_3$ | n-decyl | n-butyl | F | phenyl |

13.

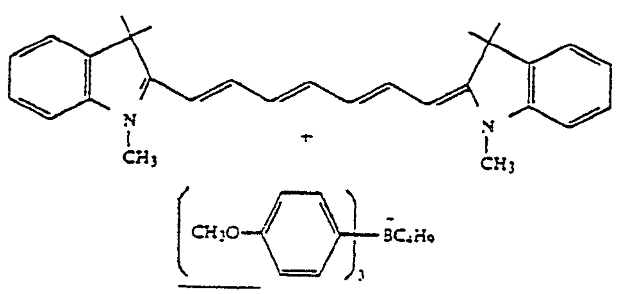

740 nm System

The cationic dye-borate anion complexes can be prepared by reacting a borate salt with a dye in a counter-ion exchange in a known manner. See Hishiki, Y., Repts. Sci. Research Inst. (1953), 29, 72-79. Useful borate salts are sodium salts such as sodium triphenylbutylborate, sodium trisanisylbutylborate and ammonium salts which as tetraethylammonium triphenyl-n-butyl borate.

The most typical examples of a free radical addition polymerizable or crosslinkable compound useful invention is an ethylenically unsaturated compound and, more specifically, a polyethylenically unsaturated compound. These compounds include both monomers having one or more ethylenically unsaturated groups, such as vinyl or allyl groups, and polymers having terminal or pendant ethylenic unsaturation. Such compounds are well known in the art and include acrylic and methacrylic esters of polyhydric alcohols such as trimethylolpropane, pentaerythritol, and the like ; and acrylate or methacrylate terminated epoxy resins, acrylate or methacrylate terminated polyesters, etc. Representative examples include ethylene glycol diacrylate, ethylene glycol dimethacrylate, trimethylolpropane triacrylate (TMPTA), pentaerythritol tetraacrylate, pentaerythritol tetramethacrylate, dipentaerythritol hydroxypentacrylate (DPHPA), hexanediol-1,6-dimethacrylate, and diethyleneglycol dimethacrylate.

The dye complex is preferably used in an amount up to about 3% by weight based on the weight of the photopolymerizable or crosslinkable species in the photohardenable composition. Most preferably, the dye complex is used in an amount of about 0.1% to 1% by weight.

We have found that film speed is improved when the dye complex is used in combination with an alkylamine and most preferably an N,N-dialkylaniline. The latter compound appears to function to remove oxygen via autoxidation and to improve indirect electron transfer. The exact mechanism is not clear.

Examples of preferred N,N-dialkylanilines are diaklylanilines substituted at one or more of the ortho, meta-, or para- position by the following groups : methyl, ethyl, isopropyl, t-butyl, 3,4-tetramethylene, phenyl, trifluoromethyl, acetyl, ethoxycarbonyl, carboxy, carboxylate, cyano, trimethylsilymethyl, trimethylsilyl, triethylsilyl, trimethylgermanyl, triethylgermanyl, trimethylstannyl, triethylstannyl, n-butoxy, n-pentyloxy, phenoxy, hydroxy,

acetyloxy, methylthio, ethylthio, isopropylthio, thio(mercapto-), acetylthio, fluoro, chloro, bromo and iodo.

Representative examples of N,N-dialkylanilines useful in practice of the present invention are 4-cyano-N,N-dimethylaniline, 4-acetyl-N,N-dimethylaniline, 4-bromo-N,N-dimethylaniline, ethyl 4-(N,N-dimethylamino)benzoate, 3-chloro-N,N-dimethylaniline, 4-chloro-N,N-diemthylaniline, 3-ethoxy-N,N-dimethylaniline, 4-fluoro-N,N-dimethylaniline, 4-methyl-N,N-dimethylaniline, 4-ethoxy-N,N-dimethylaniline, N,N-dimethylaniline, 3-hydroxy-N,N-dimethylaniline, N,N,N'-tetramethyl-1,4-dianiline, 4-acetamido-N,N-dimethylaniline, etc. N,N-dialkylanilines which are substituted with an alkyl group in the ortho-position such as 2,6-diisopropyl-N,N-dimethylaniline (DIDMA), 2,6-diethyl-N,N-dimethylaniline,N,N,2,4,6-pentamethylaniline (PMA) and 2,6-diethyl-4-octyl-N,N-dimethylaniline are preferred.

Other useful alkylamines include triethylamine tetraalkylethylenediamines such as tetramethyl- and tetraethyl-ethylenediamine, tetramethyl- and tetraethyl-diethylenetriamine, triethanolamine, etc.

The alkylamines are preferably used in concentrations of about 1-5% by weight based on monomer.

We have also found that film speed is enhanced through the addition of a thiol or a disulfide.

Representative thiols are : 2-mercaptobenzothiazole, 6-ethoxy-2-mercaptobenzothiazole, 2-mercaptobenzoxazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzenethiol, 1-phenyl-1H-tetrazole-5-thiol, 4-phenyl-4H-1,2,4-triazole-3-thiol, 2-mercaptobenzimidazole, pentaerythritol tetrakis(mercaptoacetate), pentaerythritol tetrakis(3-mercaptoproprionate), trimethylolpropane tris(mercaptoacetate), trimethylolpropane tris(3-mercaptopropionate), 4-acetamidothiophenol, mercaptosuccinic acid, dodecanethiol, 2-mercaptopyridine, 4-mercaptopyridine, 2-mercapto-3H-quinazoline, and 2-mercaptothiazoline, alkylthiophenol, alkoxythiophenol, chlorotiophenol, bromothiophenol, acylthiophenol, dialkylaminothiophenol, trifluoromethylthiophenol, hydroxythiophenol and alkylarylthiophenol wherein the number of carbons in the substituent groups ranges from 1 to 20.

Representative examples of disulfides which are particularly preferred include symmetrical and asymmetrical disulfides of the foregoing thiols. Preferred disulfides also include disulfides of 2-mercaptobenzoxazole (MBO), 6-ethoxy-2-mercaptobenzothiazole (EMBT) and phenyl mercaptotetrazole (PMT).

In one arrangement, photosensitive compositions containing dye-borate complexes may additionally include an onium salt.

With reference to Equation 1 above, the dye radical (D·) generated by photolysis of the initiator and subsequent electron transfer from the borate, is an inactive radical and could potentially be a retarder of free radical polymerization, particularly when high intensity light sources are used. It is believed that through the addition of an onium salt this inactive dye radical is converted back to a dye cation with the accompanying release of an active radical for polymerization and thus increases quantum efficiency and film speed.

Hereinbelow a variety of onium salts are suggested which may be used in practice of the present invention. The onium salt actually used will depend on a number of factors including the reduction potential of the dye radical as discussed above.

Onium salts useful in practice of the present invention include sulfonium salts, iodonium salts, pyrylium salts, thiapyrylium salts, azinium salts (see U.S. Patents 4,743,528 ; 4,743,529 ; 4,743,530 ; and 4,743,531), poly (iodonium salts) (see U.S. 4,780,511 by Crivello), poly (sulfonium salts) (e.g., see Crivello, J. Polym. Sci., Polym. Chem. Ed., 25, 3293 (1987)), diazonium salts, ferrocenium salts, and phosphonium salts.

More particularly potentially useful onium salts include : (i) triarylsulfonium hexafluorophosphates, triarylsulfonium arsenates and triarylsulfonium antimonates ; (ii) diaryliodonium hexafluorophosphates, diaryliodonium arsenates and diaryliodonium antimonates ; (iii) dialkylphenacylsulfonium tetrafluoroborates and dialkylphenacylsulfonium hexafluorophosphates ; (iv) dialkyl-4-hydroxyphenylsulfonium tetrafluoroborates and dialkyl-4-hydroxyphenylsulfonium hexafluorophosphates. Representative examples of useful onium salts include diaryliodonium salts such as $(Ph)_2I^+PF_6^-$, triarylsulfonium salts such as 4-(phenylthio)phenyldiphenylsulfonium ; sulfoxonium and carbamoylsulfoxonium salts, phosphonium salts such as $Ph_3P^+$-$C_6H_4COC_6H_5$, and pyrylium and thiapyrylium salts (where Ph = phenyl).

When the onium salt is an iodonium salt, it can be represented by the formula (III) :

$$[R^5_aR^6_bI]^+_c\ [MQ_d]^{-(d-e)} \qquad (III)$$

where $R^5$ is a monovalent aromatic organic radical, $R^6$ is a divalent organic radical, M is a metal or a metalloid and Q is a halogen, alkyl, aryl, alkylaryl, or equivalent radical, a and b are whole numbers equal to 0, 1 or 2, c is equal to d-e, e is equal to the valence of M and is an integer equal to 2 to 7 inclusive ; and d is greater than e and is an integer having a value up to 8.

Radicals included by $R^5$ can be the same or different aromatic, carbocyclic or heterocyclic radicals having from 6 to 20 carbon atoms, which can be substituted on the ring with from 1 to 4 monovalent radicals selected from $C_{(1-18)}$ alkoxy, $C_{(1-18)}$ alkyl, nitro, chloro, etc., $R^5$ is more particularly phenyl, chlorophenyl, nitrophenyl, methoxyphenyl, pyridyl, etc. Radicals included by $R^6$ are divalent radicals such as

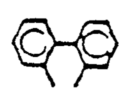 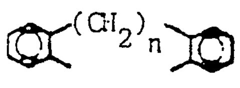

etc. Metal or metalloids included by M of formula (VIII) are transition metals such as Sb, Fe, Sn, Bi, Al, Ga, In, Ti, Zr, Sc, V, Cr, Mn, Cs, rare earth elements such as the lanthanides, for example, Cd, Pr, Nd, etc., actinides, such as Th, Pa, U, Np, etc. and metalloids such as B, P, As, etc. Complex anions included by $MQ_d^{-(d-e)}$ are, for example, $BF_4^-$, $PF_6^-$, $AsF_6^-$ , $SbF_6^-$, $FeCl_4^=$, $SnCl_6^=$, $SbCl_6^-$, $BiCl_3^=$, etc. Particularly good results are obtained when using metal or metalloid compouds having a low nuclophilicity, particularly $BF_4^-$, $SbF_6^-$, $AsF_6^-$ and $PF_6^-$.

Halonium salts, preferably iodonium salts, included by formula VIII are, for example,

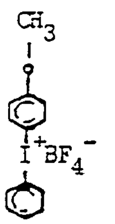 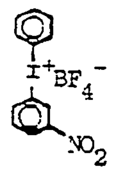 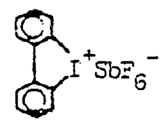 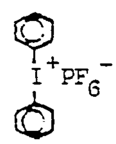 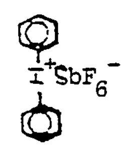 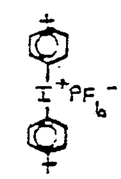 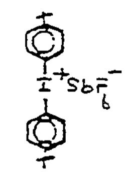

The halonium salts of formula (III) can be made by the procedures described by O. A. Ptitsyna, M. E. Pudecva, et al., Dokl, Adad Nauk, SSSR, 163, 383 (1965) ; Dokl, Chem., 163, 671 (1965). F. Marshall Beringer, M. Drexler, E. M. Gindler, J. Am Chem. Soc., 75, 2705 (1953). J. Collette, D. McGreer, R. Crawford, et al., J. Am. Chem. Soc. 78, 3819 (1956). Other aryliodonium salts include the polymeric iodonium salts which are described in U.S. Patent No. 4,780,511 and are hereby incorporated by reference.

Particularly preferred onion salts of formula (III) include salts having the following structures : $C_nH_{2n+1}C_6H_4I^+(C_6H_5)$, $(C_nH_{2n+1}C_6H_4)_2I^+$, $(C_nH_{2n+1}OC_6H_4)I^+(C_6H_5)$ and $(C_nH_{2n+1}OC_6H_4)_2I^+$ where n = 8 to 12.

When the onium salt is a sulfonium salt, it may be represented by formula (IV) :

$$[R^7{}_fR^8{}_gR^9{}_hS]^+[MQ_n]^- \qquad (IV)$$

wherein $R^7$ is a monovalent aromatic organic radical, $R^8$ is a monovalent aliphatic radical such as an alkyl radical and $R^9$ is a polyvalent organic radical forming a heterocyclic or fused ring structure, M is a metal or metalloid as defined with respect to formula (III), Q is a halogen or other radical as defined with respect to formula (III), f is a whole number equal to 0 to 3 inclusive, g is a whole number equal to 0 to 2 inclusive, h is a whole number equal to 0 or 1, and the sum of f, g and h is equal to 1 to 3 inclusive, and n is an integer equal to 4 to 6 inclusive as defined with respect to formula (III).

Examples of sulfonium salts potentially useful in practiceof the present invention include 4-(phenylthio)phenyldiphenyl sulfonium salts. Other examples of triarylsulfonium salts include :

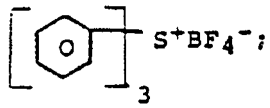

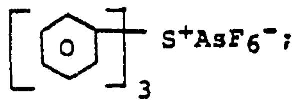

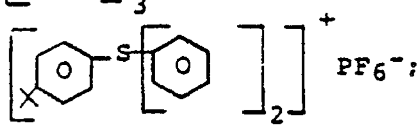

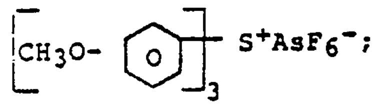

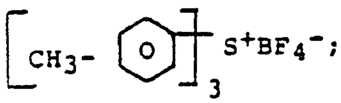

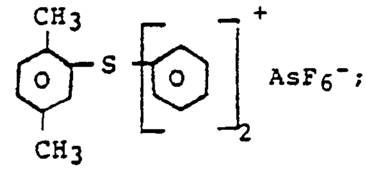

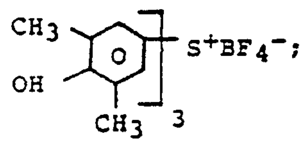 and

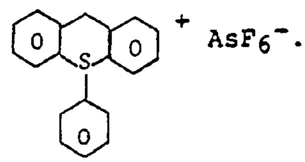

Other sulfonium salts include :

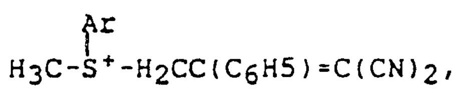

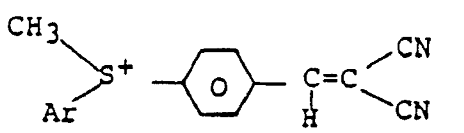 , 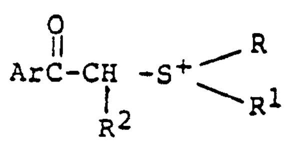

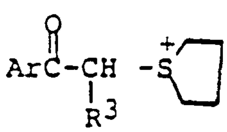 , 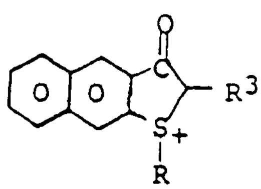 and 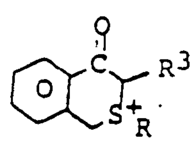

where R, $R^1$, $R^2$, $R^3$ represent alkyl, aryl, alkaryl, heterocyclic, etc. ; Ar is an aryl group including one or more fused aromatic rings and $R^3$ may be hydrogen.

In addition, phosphonium salts of formula :

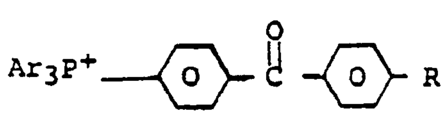 , 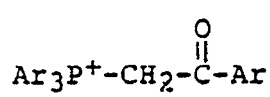

ferrocenium salts of formula :

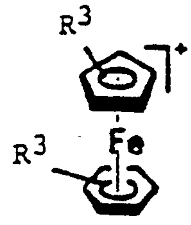 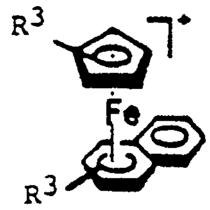 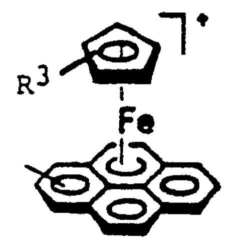

and diazonium salts of formula :

$$ArN_2{}^+$$

where Ar is as defined above. The salts listed above are examples from which useful salts may be selected. Generally, the difference between their reduction potential and the oxidation potential of the dye radical should be at least 0.2 V and the composition must be dark stable.

The onium salt may be used in an amount of about 0.01 to 5% based on the weight of monomer.

Our photohardenable compositions can be coated upon a support in a conventional manner and used as a photoresist or in photolithography to form a polymer image ; or they can be encapsulated for use in cylithographic systems as described in U.S. Patent Nos. 4,399,209 and 4,440,846 and used to control the release of an image-forming agent. The latter processes typically involve image-wise exposing the photosensitive material to actinic radiation and subjecting the layer of microcapsules to a uniform rupturing force such as pressure, abrasion, or ultrasonic energy.

Several processes can be used to form color images as explained in U.S. Patent 4,772,451. If the microcapsules are sensitive to red, green and blue light, images can be formed by direct transmission or reflection imaging or by image processing if the compositions form a false color system and they are not sensitive to visible light. Image processing may involve forming color separations (color-seps) corresponding to the red, green and blue component images and sequentially exposing the photosensitive material to three distinct bands of radiation hereinafter designated A-1, A-2, and A-3 sources through each color separation. Otherwise, it may involve electronic processing in which the image or subject to be recorded is viewed through a Dunn or matrix camera and the output from the camera electronically drives three exposure sources corresponding to A-1, A-2, and A-3. While the foregoing discussion relates to forming 3-color full color images, 4-color images are also possible. For example, microcapsules containing cyan, magenta, yellow, and black image-forming agents can be provided.

In a preferred arrangement a full color imaging system is provided in which the microcapsules are sensitive to red, green, and blue light, respectively. The photosensitive composition in at least one and possibly all three microcapsules are sensitized by one of our present photohardenable compositions.
For optimum color balance, the microcapsules are sensitive ($\lambda$ max) at about 450 nm, 550 nm, and 650 nm, respectively. Such a system is useful with visible light sources in direct transmission or reflection imaging. Such a material is useful in making contact prints or projected prints of color photographic slides. They are also useful in electronic imaging using lasers or pencil light sources of appropriate wavelengths.

The present photohardenable compositions can be encapsulated in various wall formers using techniques known in the area of carbonless paper including coacervation, interfacial polymerization, polymerization of one or more monomers in an oil, as well as various melting, dispersing, and cooling methods. To achieve maximum sensitivities, it is important that an encapsulation technique be used which provides high quality capsules which are responsive to changes in the internal phase viscosity in terms of their ability to rupture. Because the borate tends to be acid sensitive, encapsulation procedures conducted at high pH (e.g., greater than about 6) are preferred.

Oil soluble materials have been encapsulated in hydrophilic wall-forming materials such as gelatin-type materials (see U.S. Patent Nos. 2,730,456 and 2,800,457 to Green et al.) including gum arabic, polyvinyl alcohol, carboxymethylcellulose ; resorcinol-formaldehyde wall formers (see U.S. Patent No. 3,755,190 to Hart et al.) ; isocyanate wall-formers (see U.S. Patent No. 3,914,511 to Vassiliades) ; isocyanate-polyol wall-formers (see U.S. Patent No. 3,796,669 to Kiritani et al.) ; urea-formaldehyde wall-formers, particularly urea-resorcinol-formaldehyde in which oleophilicity is enhanced by the addition of resorcinol (see U.S. Patent Nos. 4,001,140; 4,087,376 and 4,089,802 by Foris et al.) ; and melamine-formaldehyde resin and hydroxypropyl cellulose (see U.S. Patent No. 4,025,455 to Shackle).

Urea-resorcinol-formaldehyde and melamine-formaldehyde capsules with low oxygen permeability are preferred. A preferred method for forming melamine-formaldehyde microcapsules is described in our European Patent Specification EP-A-0319337, and relies upon the combined use of pectin and sulfonated polystyrene

as the emulsifier/system modifier. Another useful method is described in U.S. Patent 4,608,330.

A capsule size should be selected which minimizes light attenuation. The mean diameter of the capsules used in this invention typically ranges from approximately 1 to 25 microns. As a general rule, image resolution improves as the capsule size decreases. If the capsules become too small, they may disappear in the pores or the fiber of the substrate. These very small capsules may therefore be screened from exposure by the substrate. They may also fail to rupture when exposed to pressure or other rupturing means. In view of these problems, we have determined that a preferred mean capsule diameter range is from approximately 3 to 10 microns. Technically, however, the capsules can range in size up to the point where they become visible to the human eye.

An open phase system may also be used instead of an encapsulated one. This can be done by dispersing what would otherwise be the capsule contents throughout the coating on the substrate as discrete droplets. Suitable coatings for this embodiment include polymer binders whose viscosity has been adjusted to match the dispersion required in the coating. Suitable binders are gelatin, polyvinyl alcohol, polyacrylamide, and acrylic lattices. Whenever reference is made to "capsules" and "encapsulation" without reference to a discrete capsule wall in this specification, those terms are intended to include the alternative of an open phase system.

Various image-forming agents can be used in our photosensitive materials. In one embodiment the capsules may contain a benign visible dye in the internal phase in which case images are formed by contacting the exposed imaging material under pressure with a plain paper or a paper treated to enhance its affinity for the visible dye. A benign dye is a colored dye which does not interfere with the imaging photochemistry, for example, by relaxing the excited state of the initiator or detrimentally absorbing or attenuating the exposure radiation.

In a preferred arrangement, images are formed through the reaction of a pair of chromogenic materials such as a color precursor and a color developer, either of which may be encapsulated with the photohardenable composition and function as the image forming agent. In general, these materials include colorless electron donating type compounds and are well known in the art. Representative examples of such color formers include substantially colorless compounds having in their partial skeleton a lactone, a lactam, a sultone, a spiropyran, an ester or an amido structure such as triarylmethane compounds, bisphenylmethane compounds, xanthene compounds, fluorans, thiazine compounds, spiropyran compounds and the like. Crystal Violet Lactone and Copikem X, IV and XI are often used. The color formers can be used alone or in combination. A preferred yellow color former is REAKT Yellow which is available from BASF. A preferred cyan color precursor is Cyan HD-5430 available from Hilton-Davis Chemical Co. A preferred magenta color former is Magenta HD-5100 available from Hilton-Davis Chemical Co.

The developer materials conventionally employed in carbonless paper technology are also useful.

Illustrative examples are clay minerals such as acid clay, active clay, attapulgite, etc. ; acid polymers such as phenol-formaldehyde resins, phenol acetylene condensation resins, condensates between an organic carboxylic acid having at least one hydroxy group and formaldehyde, etc. ; metal salts of aromatic carboxylic acids such as zinc salicylate, tin salicylate, zinc 2-hydroxy naphthoate, zinc 3,5 di-tert butyl salicylate, zinc 3,5-di-(-methylbenzyl) salicylate, oil soluble metal salts or phenol-formaldehyde novolak resins (e.g., see U.S. Patent Nos. 3,672,935 ; 3,732,120 and 3,737,410) such as zinc modified oil soluble phenol-formaldehyde resin as disclosed in U.S. Patent No. 3,732,120, zinc carbonate, etc., and mixtures thereof. A particularly preferred developer is one which is glossable after exposure and development as described in our European Patent Specification EP-A-0260129.

As indicated in U.S. Patent Nos. 4,399,209 and 4,440,846, the developer may be present on the photosensitive sheet (providing a so-called self-contained system) or on a separate developer sheet. In self-contained systems, the developer may be provided in a single layer underlying the microcapsules as disclosed in U.S. Patent No. 4,440,846. Alternatively, the developer can be encapsulated in non-photosensitive capsules such that upon processing, all developer capsules rupture and release developer but the color former containing capsules rupture in only the unexposed or underexposed areas which are the only areas where the color former and developer mix. Still another alternative is to encapsulate the developer in photosensitive capsules and the color former in non-photosensitive capsules.

It is not necessary for the image-forming agent to be present in the internal phase. Rather, this agent may be present in the capsule wall of a discrete capsule or in the binder of an open phase system or in a binder or coating used in combination with discrete capsules or an open phase system designed such that the image-wise ruptured capsules release a solvent for the image-forming agent. Embodiments are also envisioned in which a dye or chromogenic material is fixed in a capsule wall or binder and is released by interaction with the internal phase upon rupturing the capsules.

The most common substrate for a layer of microcapsules is a transparent substrate such as polyethylene terephthalate (PET). Translucent substrates can also be used

and preferred in certain applications is aluminized film such as aluminized PET. Paper can also be used as a substrate.

In addition to being useful in imaging systems which employ photosensitive microcapsules, our present photohardenable compositions are also useful in making printing plates (planographic or lithographic), photoresists, glass lamination, curable inks, photoadhesives and coating compositions as described in U.S. Patent 4,751,102 and 4,801,392.

The effect of antioxidants on the photospeed of the photosensitive material is shown in Table 2. In most cases investigated, the initial photospeed remains the same as the control while the photospeed after aging is significantly higher than the latter.

TABLE 2

Effect of Antioxidants on Photospeed

| Sample | | Before Aging | 80°C Aging Time (Hr) 4 | 24 | 72 |
|---|---|---|---|---|---|
| CONTROL (TMPTA/Dye Borate Initiator (.53%)/DIDMA (1%)) | | 10 | 8 | 8 | 0 |
| + BHT | (.05%) | 10 | 9 | 8 | 1 |
| + BHT | (.1%) | 9 | 9 | 8 | 1 |
| + BHT | (.4%) | 10 | 10 | 7 | 5 |
| + 398 | (.3%) | 10 | 8 | 9 | 5 |
| + 398 | (.5%) | 10 | 10 | 10 | 5 |
| + 398 | (.7%) | 11 | 12 | 10 | 5 |
| + XL-1 | (.005%) | 9 | 9 | 8 | 0 |
| + XL-1 | (.02%) | 10 | 9 | 8 | 0 |
| + XL-1 | (.1%) | 9 | 9 | 8 | 0 |
| + 398/BHT | (.5%/.02%) | 11 | 12 | 10 | 5 |
| + 398/XL-1 | (.5%/.02%) | 10 | 11 | 9 | 4 |

## Claims

1. A photohardenable or thermohardenable composition which comprises a free radical addition polymerizable material, a thermal or photo initiator, and an antioxidant including a combination of a primary antioxidant and a secondary antioxidant.

2. A photohardenable composition according to Claim 1, further characterised in that said initiator comprises an ionic dye complex capable of absorbing actinic radiation and generating a free radical.

3. A photohardenable composition according to Claim 2, further characterised in that said anionic dye complex is a cationic dye-borate complex.

4. A photohardenable composition according to Claim 3, further characterised in that said cationic dye is a cyanine dye.

5. A composition according to any preceding claim, further characterised in that said primary antioxidant is selected from hindered phenols, diarylamines and sterically hindered amines and their oxides, and nitroso compounds.

6. A composition according to Claim 5, further characterised in that said primary antioxidant is butyrate hydroxytoluene.

7. A composition according to any preceding claim, further characterised in that said secondary antioxidant is selected from phosphites and sulfides.

8. A composition according to Claim 7, further characterised in that said secondary antioxidant is 2,2′-ethylidenebis(4,6-di-t-butylphenyl) fluorophosphite.

9. A composition according to any preceding claim, further characterised in that said composition additionally contains a metal deactivator.

10. A composition according to any preceding claim, further characterised in that said composition additionally includes an onium salt.

11. Photosensitive material comprising a support having a layer of a photohardenable composition according to any preceding claim on the surface thereof.

12. Photosensitive material comprising a support having a layer of photohardenable microcapsules on the surface thereof, characterised in that at least a portion of said microcapsules contain a photohardenable composition according to any of Claims 1 to 10.

13. Photosensitive material according to Claim 12, further characterised in that said material is a full colour, panchromatic photosensitive material.

Sheet 1 of 4

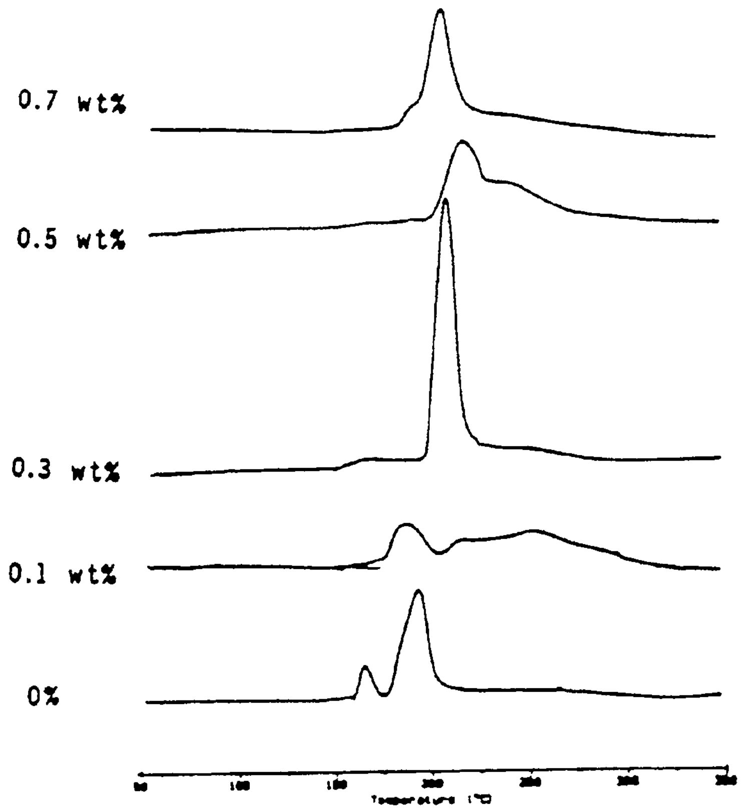


Figure 1 EFFECT OF PHOSPHITE (ETHANOX 398) ON THERMAL POLYMERIZATION OF TMPTA

Sheet 2 of 4

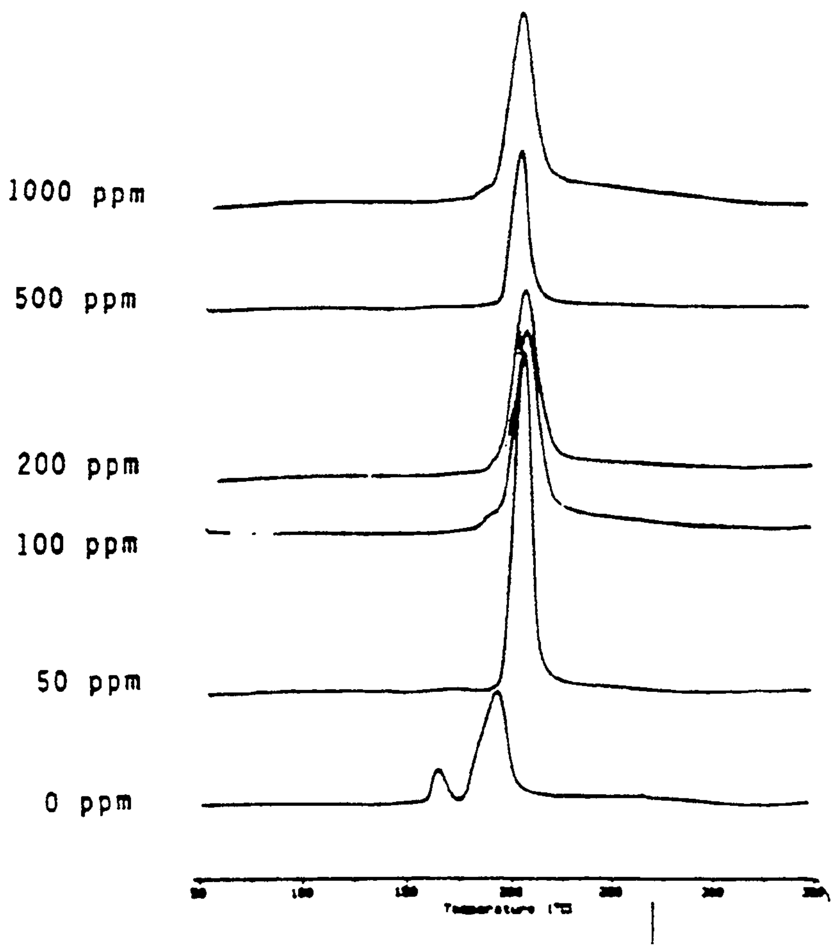


Figure 2 EFFECT OF METAL DEACTIVATOR (NAUGARD XL-1) ON THERMAL POLYMERIZATION OF TMPTA

Sheet 3 of 4

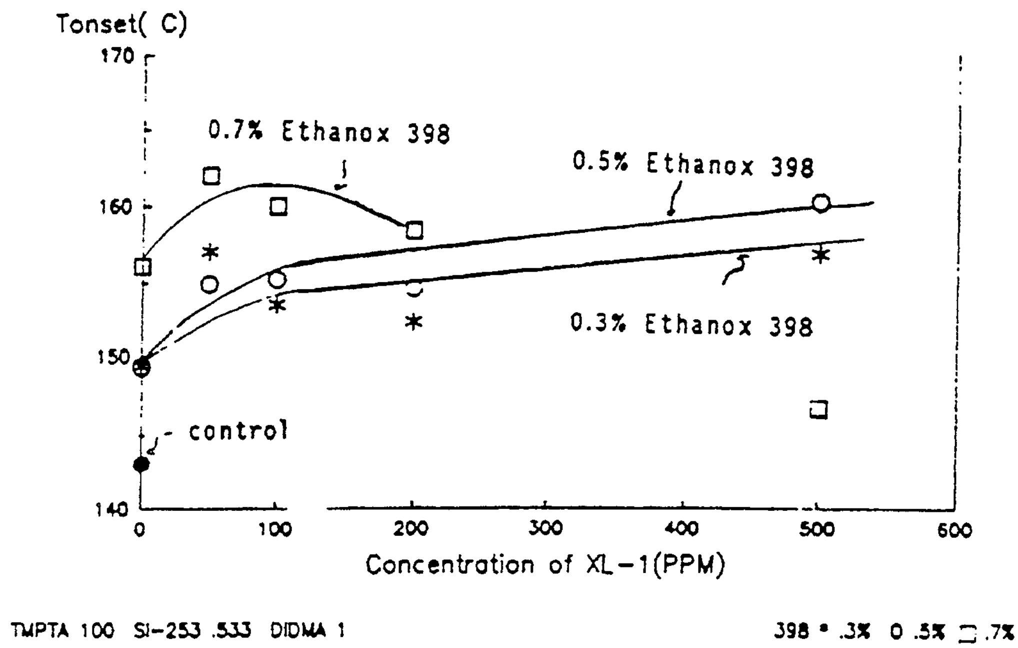


Figure 3 SYNERGISTIC EFFECT OF XL-1/ETHANOX 398 ON ONSET TEMPERATURE OF THERMAL POLYMERIZATION OF TMPTA

Sheet 4 of 4

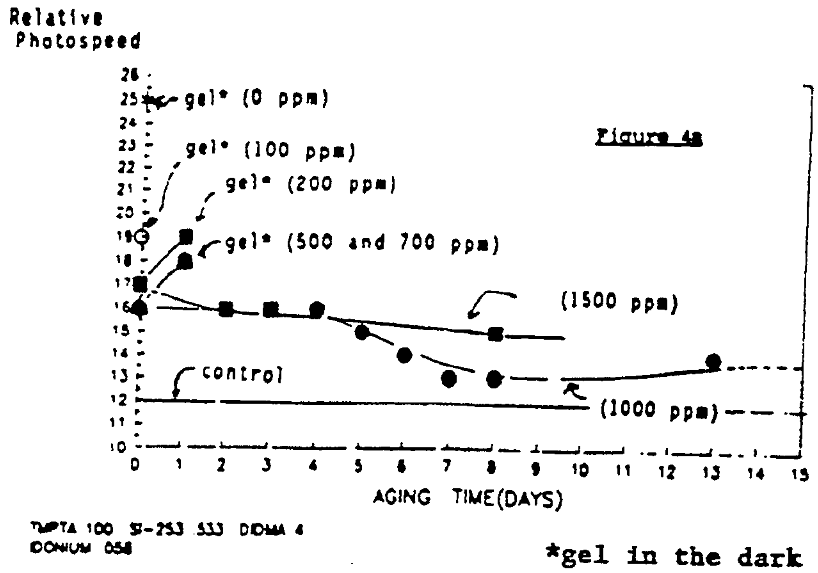


**Figure 4a** EFFECT OF BHT ON THERMAL STABILITY OF CYANINE BORATE/IODONIUM SALT/DIDMA/TMPTA SYSTEM

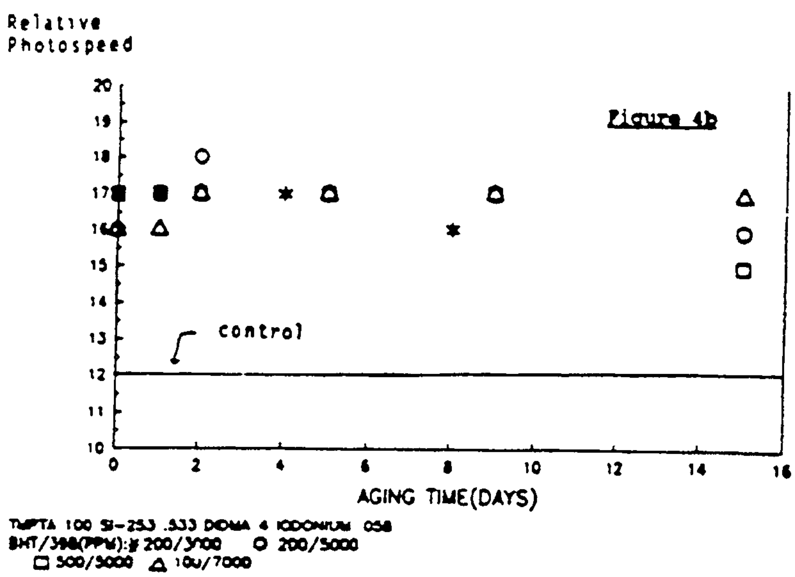


**Figure 4b** EFFECT OF BHT/ETHANOX 398 ON THERMAL STABILITY OF CYANINE BORATE/IODONIUM SALT/DIDMA/TMPTA SYSTEM